# DEMANDE DE BREVET EUROPEEN

(11) **EP 1 233 521 A1**
(43) Date de publication de la demande: **21.08.2002**
(21) Numéro de dépôt: 02290334.8
(22) Date de dépôt: 12.02.2002
(51) Int. Cl.: H03L 7/091

(54) **Procédé de synchronisation d'un signal d'horloge avec un signal de référence**

(30) Priorité: 20.02.2001 FR 0102256
(71) Demandeur: Sagem SA, 75015 Paris (FR)
(72) Inventeur: Pintaux, Jean Bernard, 75013 Paris (FR)
(74) Mandataire: Fruchard, Guy

(57) **Abrégé**

Procédé de synchronisation d'un signal d'horloge à une fréquence d'horloge (Fs) avec un signal de référence, comportant les étapes de :
- échantillonner le signal de référence par un signal d'échantillonnage ayant une fréquence (Fe) égale à un multiple entier (Nr) de la fréquence d'horloge (Fs),
- constituer des blocs contenant un nombre d'échantillons égal au multiple (Nr) de la fréquence d'horloge dans la fréquence d'échantillonnage,
- réaliser une transformée de Fourier discrète sur au moins deux blocs d'échantillons,
- déterminer à partir de la transformée de Fourier discrète au moins une information relative à un écart de phase entre le signal de référence et le signal d'horloge et au moins une information relative à une variation de l'écart de phase en relation avec au moins une raie sélectionnée (R1) du signal échantillonné, et
- corriger respectivement l'écart de phase et la fréquence d'horloge en fonction de ces informations.

## Description

La présente invention concerne un procédé de synchronisation d'un signal d'horloge avec un signal de référence.

On sait que les équipements de traitement numérique sont en général équipés d'une horloge numérique servant au cadencement des traitements et à la génération de signaux périodiques nécessaires au fonctionnement de l'équipement. Afin que l'équipement de traitement numérique puisse communiquer avec d'autres équipements auxquels il est relié, il est nécessaire que les horloges des différents équipements soient synchronisées entre elles. Afin de réaliser cette synchronisation, un signal de référence est transmis aux différentes horloges, soit à partir d'un signal de conditionnement, soit par extraction à partir d'un signal transmettant des données, et la synchronisation du signal d'horloge avec le signal de référence est généralement effectuée à l'aide d'une boucle d'asservissement dénommée boucle à verrouillage de phase . La boucle à verrouillage de phase comporte un comparateur de phase qui mesure au cours du temps l'écart de phase entre le signal d'horloge et le signal de référence et en déduit après filtrage une erreur de phase qui fait l'objet d'une correction. L'écart de phase peut avoir pour origine un simple décalage temporel entre le signal de référence et le signal d'horloge ou une différence de fréquence entre le signal d'horloge et le signal de référence. Dans ce dernier cas, l'écart de phase évolue de façon linéaire au cours du temps. Le comparateur de phase et le filtrage de boucle travaillent dans le domaine temporel de sorte que pour différencier l'écart de phase dû à un décalage initial de l'écart de phase dû à une différence de fréquence il est donc généralement prévu d'accumuler un nombre important d'échantillons successifs.

Selon l'invention, on propose un procédé de synchronisation d'un signal d'horloge qui est à une fréquence d'horloge avec un signal de référence, ce procédé comportant les étapes de : échantillonner le signal de référence par un signal d'échantillonnage ayant une fréquence égale à un multiple entier de la fréquence d'horloge, constituer des blocs contenant un nombre d'échantillons égal au multiple de la fréquence d'horloge dans la fréquence d'échantillonnage, réaliser une transformée de Fourier discrète sur au moins deux blocs successifs, déterminer à partir de la transformée de Fourier discrète au moins une information relative à une valeur d'un écart de phase entre le signal de référence et le signal d'horloge et au moins une information relative à une variation de l'écart de phase en relation avec au moins une raie sélectionnée du signal échantillonné, et corriger respectivement l'écart de phase et la fréquence d'horloge en fonction de ces informations.

Ainsi, la boucle de correction travaille dans le domaine fréquenciel et dans le cas d'un signal de référence et d'un signal d'horloge ne comportant pas-de bruit, il est possible de réaliser une correction d'écart à partir de deux blocs d'échantillons seulement.

Selon une version avantageuse de l'invention, le procédé comporte en outre les étapes de déterminer à partir de la transformée de Fourier discrète, une information relative à une amplitude d'une raie du signal échantillonné correspondant à une raie d'amplitude nulle du signal de référence, et de valider une correction de la fréquence d'horloge en fonction de cette information.

On assure ainsi un contrôle de l'information relative à la variation de l'écart de phase.

Selon un autre aspect avantageux de l'invention, le procédé comporte en outre l'étape de faire une moyenne des transformées de Fourier discrètes sur plusieurs blocs d'échantillons. On réduit ainsi le bruit parasite et on évite donc d'effectuer des corrections inutiles qui seraient générées par le bruit parasite.

D'autres caractéristiques et avantages de l'invention apparaîtront à la lecture de la description qui suit d'un mode de mise en oeuvre particulier non limitatif de l'invention, en relation avec les figures ci-jointes parmi lesquelles :
- la figure 1 est un schéma par blocs d'une boucle de synchronisation mettant en oeuvre le procédé selon l'invention,
- la figure 2 est une représentation par blocs détaillée d'un mode de mise en oeuvre d'une partie des étapes de la figure 1 en relation avec une fréquence d'échantillonnage égale à quatre fois la fréquence d'horloge,
- la figure 3 est un schéma analogue à celui de la figure 1, pour une variante de mise en oeuvre du procédé selon l'invention.

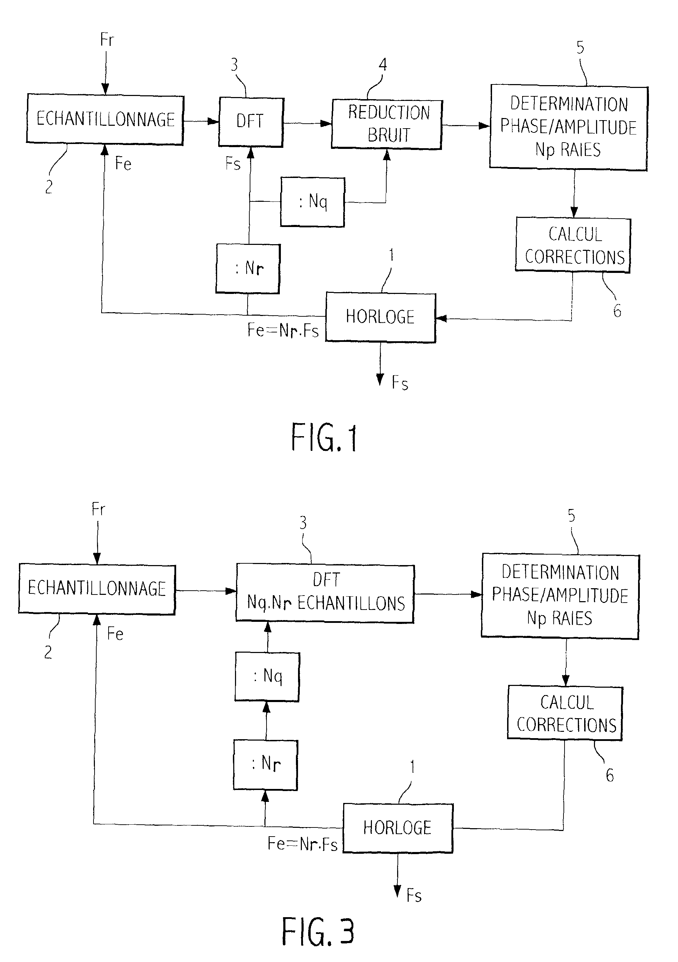

En référence à la figure 1, la boucle de verrouillage comporte de façon connue en soi une horloge 1 générant un signal d'horloge à une fréquence Fs qui doit être synchronisée avec un signal de référence à une fréquence Fr.

Selon l'invention, on effectue tout d'abord un échantillonnage 2 du signal de référence qui est à la fréquence Fr par un signal d'échantillonnage à une fréquence Fe qui est un multiple entier Nr de la fréquence du signal d'horloge. Le signal d'échantillonnage est généré par l'horloge elle-même.

Les échantillons produits sont envoyés à un module 3 de calcul d'une transformée de Fourier discrète DFT. A cet effet, le module 3 constitue des blocs contenant un nombre d'échantillons égal au multiple Nr utilisé pour générer la fréquence d'échantillonnage à partir de la fréquence d'horloge. A cet effet, la fréquence d'échantillonnage est divisée par le multiple Nr pour obtenir un cadencement du module 3 à une fréquence Fs. Le nombre d'échantillons de chaque bloc correspond donc sensiblement à une période du signal de référence.

Dans le mode de mise en oeuvre préféré illustré, le bruit éventuellement contenu dans le signal de référence, dont l'amplitude moyenne peut être considérée comme nulle, est réduit dans un module de réduction de bruit 4 en effectuant une accumulation des résultats de la transformée de Fourier discrète sur un nombre Nq de blocs suffisant pour que la moyenne nulle des perturbations puisse être considérée comme sensiblement atteinte. En pratique, l'accumulation des Nq résultats est réalisée en utilisant un signal de cadencement obtenu en divisant par Nq le signal de cadencement du module de réalisation de la transformée de Fourier discrète.

Les résultats ainsi obtenus sont représentatifs de l'amplitude et de la phase des raies du spectre de raies qui caractérise tout signal périodique dans le domaine fréquenciel. Par ailleurs, dans le domaine fréquentiel, la phase des raies d'amplitude non nulle est représentative de l'écart de phase entre le signal d'horloge et le signal de référence et la variation de phase d'une même raie sur des blocs successifs est représentative d'une différence de fréquence entre le signal d'horloge et le signal de référence. En outre, lorsque le signal de référence comporte des raies d'amplitude nulle et lorsque la fréquence du signal d'horloge diffère de la fréquence de référence l'amplitude de ces mêmes raies dans le signal échantillonné est non nulle de sorte que l'analyse de l'amplitude des raies qui devraient avoir une amplitude nulle permet de vérifier s'il existe un écart de fréquence entre le signal d'horloge et le signal de référence.

Le procédé selon l'invention utilise ces propriétés, et à cet effet la valeur de phase et la variation de phase, ainsi que le cas échéant l'amplitude, d'un nombre Np de raies sélectionnées sont déterminées dans un module 5 à partir des résultats moyennés de la transformée de Fourier discrète. Ces informations sont utilisées dans un module 6 de calcul des corrections à apporter à la fréquence et à la phase du signal d'horloge, ces corrections étant transmises à l'horloge 1.

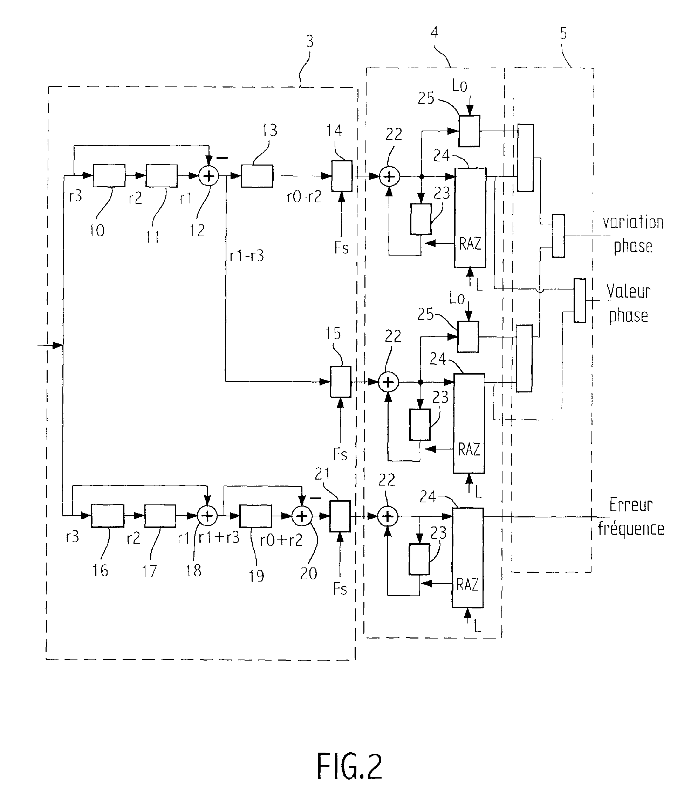

La figure 2 illustre un mode de réalisation simple du module de calcul de la transformée de Fourier discrète 3, du module de réduction de bruit 4 et du module 5 de détermination des informations relatives à la phase et à l'amplitude des raies du signal échantillonné. Le mode de réalisation de la figure 2 peut être utilisé en particulier lorsque le signal de référence est un signal périodique triangulaire à pente symétrique, c'est-à-dire que le spectre de ce signal ne possède pas de raies aux fréquences multiples paires de la fréquence du signal de référence.

Dans le mode de réalisation illustré, on a choisi une fréquence d'échantillonnage égale à quatre fois la fréquence d'horloge (Nr = 4). Pour chaque période du signal de référence on obtient donc quatre échantillons r0, r1 r2 et r3. La transformée de Fourier discrète fournit alors quatre raies R0, R1, R2 et R3 parmi lesquelles la raie R0 est représentative de la composante continue du signal et ne présente donc pas d'intérêt du point de vue de la mise en oeuvre du procédé selon l'invention, la raie R1 est d'amplitude non nulle et correspond à la fréquence de référence, la raie R2 correspond à deux fois la fréquence de référence et est normalement d'amplitude nulle, et la raie R3 qui correspond à trois fois la fréquence de référence est identique à la raie R1. Dans ce cas, seules les raies R1 et R2 présentent donc un intérêt.

A partir des quatre échantillons prélevés à la sortie de l'échantillonneur 2, la raie R1 est définie par un nombre complexe dont la partie réelle est donnée par la différence r0 - r2 et dont la partie imaginaire est donnée par la différence r1 - r3 tandis que l'amplitude de la raie R2 est donnée par la formule r0 + r2 - (r1 + r3).

Le calcul des informations utiles relatives aux raies R1 et R2 peut donc être obtenu par de simples sommations comme illustré par la figure 2. A cet effet, le module de calcul de la transformée de Fourier discrète 3 comporte deux voies parallèles sur lesquelles les échantillons sont successivement envoyés. La première voie comporte un temporisateur 10 réalisant une temporisation quart de période, c'est à dire une temporisation égale au quart de la période du signal d'horloge. L'entrée du temporisateur 10 est reliée à l'entrée du module 3 et sa sortie est reliée à l'entrée d'un second temporisateur 11 assurant également une temporisation quart de période et dont la sortie est reliée à une entrée d'un sommateur 12 ayant une seconde entrée inverseuse de signe reliée à l'entrée du temporisateur 10. La sortie du sommateur 12 est reliée d'une part à un temporisateur 13 lui-même relié à un organe de lecture 14 cadencé à la fréquence Fs, et d'autre part directement à un organe de lecture 15 également cadencé à la fréquence Fs. La seconde voie comporte un temporisateur quart de période 16 dont l'entrée est reliée à l'entrée du module 3 et dont la sortie est reliée à un temporisateur quart de période 17 lui-même relié à une entrée d'un sommateur 18 ayant une seconde entrée reliée à l'entrée du temporisateur 16. La sortie du sommateur 18 est reliée à un temporisateur quart de période 19 dont la sortie est reliée à une entrée d'un sommateur 20 ayant une seconde entrée inverseuse de signe reliée à l'entrée du temporisateur 19. La sortie du sommateur 20 est reliée à un organe de lecture 21 cadencé à la fréquence Fs. Lors du déclenchement de la lecture à chacun des organes de lecture 14, 15 et 21, ce déclenchement étant réalisé de façon synchrone avec l'échantillonnage, l'échantillon r3 est présent à l'entrée des temporisateurs 10 et 16, l'échantillon r2 à l'entrée des temporisateurs 11 et 17, et l'échantillon r1 à l'entrée des sommateurs 12 et 18. Compte tenu du décalage assuré par le temporisateur 13, la sortie de celui-ci qui est alors lue par l'organe de lecture 14 sera r0 - r2 tandis que l'organe de lecture 15 lit alors la valeur r1 - r3 et l'organe de lecture 21 lit la valeur r0 + r2 - (r1 + r3).

Les valeurs qui sont ainsi relevées par les organes de lecture 14, 15 et 21 sont moyennées dans le module 4 qui comprend, associé à chaque sortie d'un organe de lecture, un circuit comprenant un sommateur 22 ayant une seconde entrée reliée à la sortie d'un temporisateur 23 assurant une temporisation égale à la période du signal d'horloge et dont l'entrée est reliée à la sortie du sommateur 22. La sortie du sommateur 22 est en outre reliée à un organe de lecture 24 cadencé à une fréquence L obtenue en divisant la fréquence Fs par le nombre Nq de résultats que l'on souhaite moyenner. Chaque cadencement de l'organe de lecture 24 assure en outre une remise à zéro de la boucle comprenant le temporisateur 23. Pour les circuits d'accumulation associés aux organes de lecture 14 et 15, un organe de lecture 25 est en outre relié à la sortie du sommateur 22 et est cadencé par un signal L0 à la même fréquence que le signal L mais décalé de celui-ci par un nombre entier de périodes du signal d'horloge. Les sorties des organes de lecture 24 associés aux organes de lectures 14 et 15 sont donc respectivement représentatives de la partie réelle et la partie imaginaire de la phase de la raie R1 et servent à déterminer dans le module de calcul 5 l'écart de phase entre le signal d'horloge et le signal de référence. Les sorties des organes de lecture 24 et 25 respectivement reliés aux organes de lecture 14 et 15 sont représentatives de la partie réelle et de la partie imaginaire de la variation de phase de la raie R1 et servent donc à déterminer dans le module de calcul 5 la variation de l'écart de phase entre le signal d'horloge et le signal de référence. Lorsque l'écart de phase est constant ceci signifie que la fréquence du signal d'horloge est égale à celle du signal de référence. La sortie de l'organe de lecture 24 associé à l'organe de lecture 21 est représentative de l'amplitude de la raie R2. Sa valeur permet donc de contrôler l'information donnée sur la variation de phase, l'absence de variation de phase sur la raie R1 devant en principe être simultanée avec une amplitude nulle de la raie R2. Compte tenu du bruit résiduel qui peut subsister en dépit du traitement pour éliminer celui-ci, on peut considérer qu'en dessous d'un seuil d'amplitude de la raie R2 la fréquence du signal d'horloge est égale à la fréquence du signal de référence et ne pas tenir compte de l'information donnée par la raie R1 sur la variation de l'écart de phase pour le calcul de la correction à appliquer au module d'horloge.

La figure 3 illustre une variante de réalisation dans laquelle la réduction de bruit est intégrée au calcul de la transformée de Fourier discrète en effectuant ce calcul sur un plus grand nombre d'échantillons, par exemple en divisant la fréquence de cadencement Fs par le nombre Nq de façon à réaliser une transformée de Fourier discrète sur Nq.Nr échantillons correspondants à Nq période du signal de référence. Les raies du spectre du signal de référence se trouvent alors situées à des multiples entiers de Nq.Fr. La réalisation de la transformée de Fourier discrète n'est pas plus complexe que pour Nr échantillons mais permet d'obtenir un plus grand choix de raies pouvant fournir des informations sur des écarts de phase, en particulier les raies dont l'amplitude devrait normalement être nulle.

Bien entendu, l'invention n'est pas limitée aux modes de mise en oeuvre décrits et on peut y apporter des variantes de réalisation sans sortir du cadre de l'invention tel que défini par les revendications.

En particulier, le procédé selon l'invention peut être mis en oeuvre en utilisant uniquement les informations relatives à l'écart de phase et à la variation de l'écart de phase sans effectuer de contrôle par l'analyse de l'amplitude des raies du signal échantillonné correspondant aux raies nulles du signal de référence.

Le procédé selon l'invention peut être mis en oeuvre avec un signal de référence dont le spectre ne compte pas de raie nulle. Dans ce cas si l'on veut effectuer un contrôle sur des raies nulles on peut prévoir un traitement préalable de mise en forme spectrale, tel qu'un redressement ou une élévation à une puissance, pour créer des raies nulles.

Bien qu'en relation avec la figure 2 l'invention ait été décrite en utilisant seulement une raie d'amplitude nulle et une raie d'amplitude non nulle, on peut prévoir en augmentant Nr d'effectuer des calculs sur plusieurs raies et d'affecter les résultats de ces calculs d'une pondération avant de déterminer les corrections effectives à assurer sur le signal d'horloge.

On remarquera que le procédé selon l'invention permet non seulement de mettre le signal d'horloge exactement en phase avec le signal de référence, mais également de générer un signal d'horloge avec un écart de phase prédéterminé par rapport au signal de référence.

D'une façon générale, le nombre Nr d'échantillons utilisés et le nombre Np de raies sélectionnées dépendra de la complexité du signal de référence et de la précision recherchée en relation avec un coût acceptable, le coût étant généralement d'autant plus élevé que le nombre d'échantillons traités est plus élevé.

## Revendications

1. Procédé de synchronisation d'un signal d'horloge qui est à une fréquence d'horloge (Fs) avec un signal de référence, **caractérisé en ce qu'**il comporte les étapes de :
- échantillonner le signal de référence par un signal d'échantillonnage ayant une fréquence (Fe) égale à un multiple entier (Nr) de la fréquence d'horloge (Fs),
- constituer des blocs contenant un nombre d'échantillons égal au multiple (Nr) de la fréquence d'horloge dans la fréquence d'échantillonnage,
- réaliser une transformée de Fourier discrète sur au moins deux blocs d'échantillons,
- déterminer à partir de la transformée de Fourier discrète au moins une information relative à un écart de phase entre le signal de référence et le signal d'horloge et au moins une information relative à une variation de l'écart de phase en relation avec au moins une raie sélectionnée (R1) du signal échantillonné, et
- corriger respectivement l'écart de phase et la fréquence d'horloge en fonction de ces informations.

2. Procédé de synchronisation selon la revendication 1, **caractérisé en ce qu'**il comporte en outre les étapes de déterminer à partir de la transformée de Fourier discrète une information relative à une amplitude d'une raie (R2) du signal échantillonné correspondant à une raie d'amplitude nulle du signal de référence et valider une correction de la fréquence d'horloge en fonction de cette information.

3. Procédé de synchronisation selon la revendication 1 ou la revendication 2, **caractérisé en ce qu'**il comporte en outre l'étape de faire une moyenne des transformées de Fourier discrète sur plusieurs (Nq) blocs d'échantillons.

4. Procédé de synchronisation selon la revendication 3, **caractérisé en ce que** la transformée de Fourier discrète est effectuée sur un nombre d'échantillons correspondant au produit du multiple (Nr) de la fréquence d'horloge dans le signal d'échantillonnage (Fe) et du nombre (Nq) de blocs servant à effectuer une moyenne.

5. Procédé de synchronisation selon l'une quelconque des revendications précédentes, **caractérisé en ce que** les informations relatives à l'écart de phase et à la variation de phase sont déterminées en relation avec plusieurs (Np) raies sélectionnées, et la correction du signal d'horloge est effectuée après pondération des différentes informations obtenues.
